# FASCICULE DE BREVET EUROPEEN

(11) **EP 4 457 840 B1**
(45) Date de publication et mention de la délivrance du brevet: **18.11.2026**
(21) Numéro de dépôt: 22839381.5
(22) Date de dépôt: 26.12.2022
(51) Int. Cl.: G21C 3/07, G21C 21/02, C23C 14/16, B23B 9/00

(54) **GAINE DE COMBUSTIBLE NUCLÉAIRE ET PROCÉDÉ DE FABRICATION D'UNE TELLE GAINE**
KERNBRENNSTOFFUMMANTELUNG UND VERFAHREN ZUR HERSTELLUNG SOLCH EINER UMMANTELUNG
NUCLEAR FUEL CLADDING AND METHOD FOR PRODUCING SUCH CLADDING

(30) Priorité: 27.12.2021 FR 2114546
(43) Date de publication de la demande: 06.11.2024
(73) Titulaire: FRAMATOME, 92400 Courbevoie (FR)
(72) Inventeur: BISCHOFF, Jérémy, 69003 Lyon (FR); BARBERIS, Pierre, 73400 Ugine (FR); BUCHANAN, Karl, 69740 Genas (FR)
(74) Mandataire: Lavoix
(86) Numéro de dépôt international: PCT/EP2022/087846
(87) Numéro de publication internationale: WO 2023/126387

(56) Documents cités:
- WO-A1-2022/023516
- US-A1- 2018 366 234
- US-A1- 2020 020 456
- US-B2- 9 721 676

## Description

La présente invention concerne le domaine des gaines de combustible nucléaire (ci-après aussi nommées « gaines ») destinée à contenir du combustible nucléaire, en particulier des gaines de crayon de combustible nucléaire, et leur procédé de fabrication.

Le combustible nucléaire incluant la matière fissile est généralement contenu dans une gaine étanche qui évite la dispersion du combustible nucléaire.

Les assemblages de combustible nucléaire utilisés dans les réacteurs à eau légère ou à eau lourde comprennent généralement un faisceau de crayons de combustible nucléaire, chaque crayon de combustible nucléaire comprenant une gaine tubulaire contenant du combustible nucléaire, la gaine étant fermée à chacune de ses deux extrémités par un bouchon respectif.

Les gaines des assemblages de combustible nucléaire sont réalisées par exemple en alliage à base de zirconium. De tels alliages à base de zirconium présentent des performances élevées en conditions normales d'utilisation dans les réacteurs nucléaires.

Cependant, ils peuvent atteindre leurs limites notamment en terme de température lors de conditions accidentelles sévères, comme par exemple lors d'un accident de perte de fluide de refroidissement (ou LOCA pour « Loss Of Coolant Accident » en anglais).

Lors d'un tel évènement, la température dans le cœur du réacteur nucléaire peut atteindre plus de 800°C et le fluide de refroidissement se présente essentiellement sous forme de vapeur d'eau.

Ceci peut causer une dégradation rapide de la gaine d'un crayon de combustible nucléaire, avec notamment un dégagement d'hydrogène et une oxydation rapide de la gaine conduisant à sa fragilisation voire à son éclatement, et donc au relâchement de combustible nucléaire hors de la gaine.

Il est possible de prévoir une gaine comprenant un substrat réalisé en alliage à base de zirconium et recouvert d'un revêtement de protection réalisé en chrome.

Un tel revêtement de protection en chrome permet généralement d'augmenter la tolérance de la gaine en conditions normales et en conditions accidentelles. Cependant la résistance à l'usure d'un tel revêtement de protection en chrome est relativement faible.

US9721676B2 divulgue une gaine de crayon de combustible nucléaire comprenant un substrat en alliage de zirconium recouvert par une première composition, la première composition comprenant par exemple du nickel, du cuivre et/ou du palladium, et une deuxième composition, la deuxième composition contenant l'élément chrome.

Un des buts de l'invention est de proposer une gaine qui présente un comportement amélioré en conditions normales et en conditions accidentelles, tout en présentant une résistance à l'usure améliorée.

A cet effet, l'invention propose une gaine de combustible nucléaire selon la revendication 1.

L'ajout d'une couche additionnelle réalisée en en chrome pur ou en un matériau constitué de chrome et, en outre, d'oxygène et/ou d'azote, en particulier un matériau constitué d'oxyde de chrome, de nitrure de chrome, d'oxynitrure de chrome ou d'une combinaison de ces composés ou réalisée en chrome dopé à l'oxygène et/ou à l'azote, permet d'améliorer encore les performances de la gaine recouverte d'une couche principale réalisée en chrome pur, en particulier en terme de résistance à l'usure, de résistance aux rayures et/ou de perméation aux produits de fission et autres produits issus de la corrosion, de résistance à l'hydruration et d'absorption d'hydrogène par le substrat, selon que la couche additionnelle est située sur la couche principale ou sous la couche principale.

Des caractéristiques optionnelles de la gaine de combustible nucléaire sont définies aux revendications 2 à 9.

L'invention concerne également un procédé de fabrication selon la revendication 10.

Des caractéristiques optionnelles du procédé de fabrication sont définies aux revendications 11 à 19.

L'invention et ses avantages seront mieux compris à la lecture de la description qui va suivre, donnée uniquement à titre d'exemple non limitatif, et faite en référence aux dessins annexés, sur lesquels :
- la Figure 1 est une vue schématique en coupe longitudinale d'un crayon de combustible nucléaire illustrant une gaine du crayon de combustible nucléaire;
- les Figures 2 à 6 sont des vues schématiques axiales de gaines de crayon de combustible nucléaire ;
- la Figure 7 est une vue en coupe d'un revêtement de protection ;
- la Figure 8 est une vue schématique d'une installation de dépôt d'un revêtement sur un substrat par dépôt physique en phase vapeur.

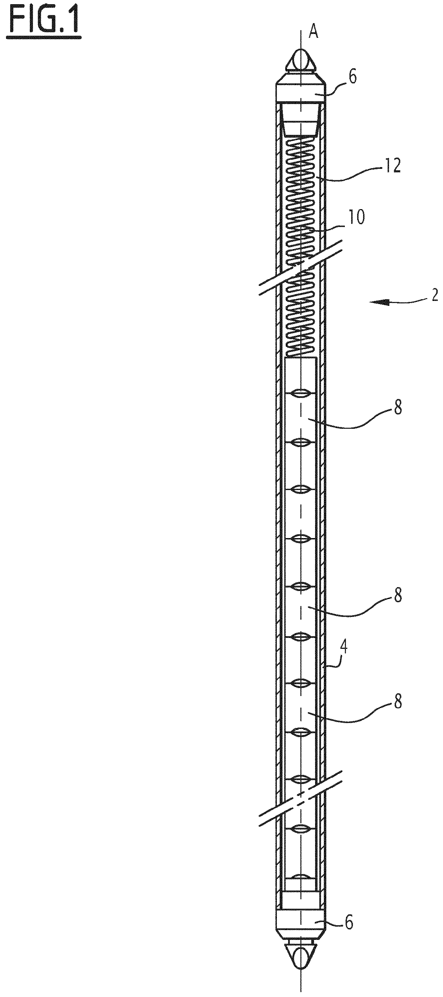

La Figure 1 illustre un crayon de combustible nucléaire 2 destiné à être utilisé dans un réacteur à eau légère, en particulier un réacteur à eau sous pression (ou PWR pour « Pressurized Water Reactor ») ou un réacteur à eau bouillante (ou BWR pour « Boiling Water Reactor »), un réacteur de type « VVER », un réacteur de type « RBMK », ou un réacteur à eau lourde, par exemple de type « CANDU ».

Le crayon de combustible nucléaire 2 présente la forme d'une tige allongée suivant un axe longitudinal A.

Le crayon de combustible nucléaire 2 comprend une gaine 4 contenant du combustible nucléaire. La gaine 4 est tubulaire et s'étend suivant l'axe longitudinal A. La gaine 4 est fermée de manière étanche à chacune de ses extrémités par un bouchon 6 respectif.

Le combustible nucléaire se présente par exemple sous la forme d'un empilement de pastilles 8 empilées axialement à l'intérieur de la gaine 4, chaque pastille 8 contenant du matériau fissile. L'empilement de pastilles 8 est aussi appelée « colonne fissile ».

Le crayon de combustible nucléaire 2 comprend un ressort 10 disposé à l'intérieur de la gaine 4, entre l'empilement de pastilles 8 et l'un des bouchons 6, pour pousser l'empilement de pastilles 8 vers l'autre bouchon 6. Un vide ou plenum 12 est présent entre l'empilement de pastilles 8 et le bouchon 6 sur lequel le ressort 10 prend appui.

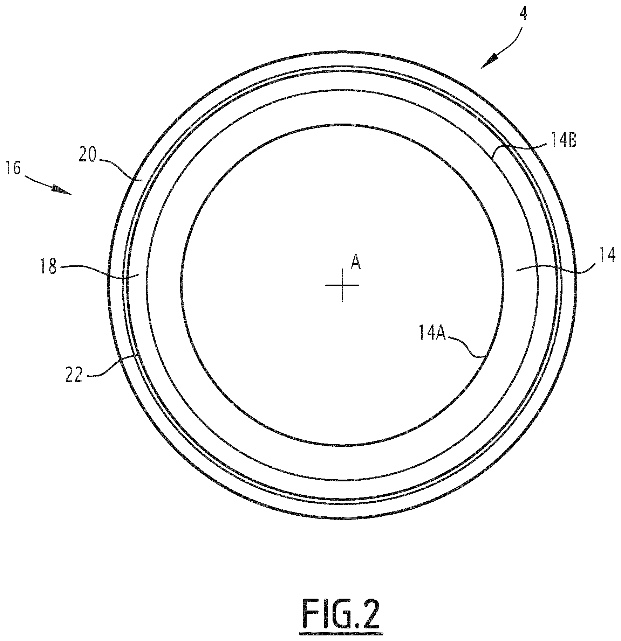

La Figure 2 représente une vue axiale d'une gaine 4 de crayon de combustible nucléaire 2, destinée à contenir du combustible nucléaire.

La gaine 4 comprend un substrat 14 muni d'un revêtement de protection 16.

La gaine 4 est tubulaire et s'étend suivant un axe longitudinal A.

De manière correspondante, le substrat 14 est tubulaire et s'étend suivant l'axe longitudinal A. Le substrat 14 est un tube.

Le substrat 14 présente par exemple un diamètre externe compris entre 8 mm et 15 mm, en particulier entre 9 mm et 13 mm, et/ou une longueur comprise entre 1 m et 5 m, en particulier entre 2 m et 5 m.

Le substrat 14 est réalisé en zirconium pur ou en alliage à base de zirconium.

L'expression « zirconium pur » désigne un matériau contenant au moins 99 % en poids de zirconium et l'expression « alliage à base de zirconium » désigne un alliage contenant au moins 95% en poids de zirconium. L'alliage à base de zirconium est par exemple choisi parmi un des alliages connus tels que M5, ZIRLO, E110, HANA, N36, Zircaloy-2 et Zircaloy-4.

Le substrat 14 présente une surface interne 14A tournée vers l'intérieur de la gaine 4 et délimitant l'espace de réception du combustible nucléaire.

Le substrat 14 présente une surface externe 14B destinée à être tournée vers l'extérieur de la gaine 4. La surface externe 14B est opposée à la surface interne 14A.

La surface interne 14A est ici la surface tournée vers l'intérieur du substrat 14 en forme de tube et la surface externe 14B est la surface tournée vers l'extérieur du substrat 14 en forme de tube.

Le revêtement de protection 16 recouvre la surface externe 14B du substrat 14. Le revêtement de protection 16 a pour fonction de protéger la surface externe 14B du substrat 14 de l'environnement extérieur. En l'absence de revêtement de protection 16, la surface externe 14B de la gaine 14 serait exposée à l'environnement extérieur.

Le revêtement de protection 16 est multicouche. Le revêtement de protection 16 comprend plusieurs couches superposées.

Le revêtement de protection 16 comprend une couche principale 18 et une ou plusieurs couches additionnelles 20.

La couche principale 18 est réalisée en chrome pur.

Par « réalisé en chrome pur », on entend réalisé dans un matériau comprenant au moins 99% en poids de chrome. Le reste du matériau est constitué d'inévitables impuretés.

Chaque couche additionnelle 20 est située sur la couche principale 18 ou sous la couche principale 18. Chaque couche additionnelle 20 située sur la couche principale 18 est située du côté de la couche principale 18 opposé au substrat 14. Chaque couche additionnelle 20 située sous la couche principale 18 est située entre la couche principale 18 et le substrat 14.

Le revêtement de protection 16 comprend par exemple une ou plusieurs couches additionnelles 20 situées sur la couche principale 18. La couche principale 18 est située entre le substrat 14 et chaque couche additionnelle 20 située sur la couche principale 18.

Le revêtement de protection 16 comprend par exemple une ou plusieurs couches additionnelles 20 situées sous la couche principale 18. La couche principale 18 est située entre le substrat 14 et chaque couche additionnelle 20 située sous la couche principale 18.

De préférence, la couche superficielle du revêtement de protection 16 est une couche additionnelle 20. La couche superficielle du revêtement de protection 16 est la couche la plus externe du revêtement de protection 16. Cette couche superficielle est en contact avec l'environnement extérieur.

Chaque couche additionnelle 20 est réalisée en chrome pur ou dans un matériau constitué de chrome et, en outre, d'oxygène et/ou d'azote, avec la présence éventuelle d'inévitables impuretés.

De préférence, le matériau de chaque couche additionnelle 20 constitué de chrome et, en outre, d'oxygène et/ou d'azote, avec la présence éventuelle d'inévitables impuretés, comprend au plus 1% en poids d'impuretés, de préférence au plus 0,5% en poids d'impuretés.

La présence d'impuretés peut être dû par exemple à la présence de ces impuretés dans le matériau de base utilisé pour obtenir le matériau de la couche additionnelle 20.

Par exemple, chaque couche additionnelle 20 est réalisée en chrome pur, en oxyde de chrome, en particulier en Cr₂O₄ ou en un oxyde de chrome amorphe, en nitrure de chrome, en oxynitrure de chrome ou en une combinaison de ces matériaux ou est réalisée en chrome métallique dopé avec des atomes d'oxygène et/ou des atome d'azote ou est réalisé en chrome métallique dans lequel sont implantés des atomes d'oxygène et/ou des atomes d'azote.

Un matériau en chrome métallique dopés avec des atomes d'oxygène et/ou des atomes d'azote ou dans lequel sont implantés des atomes d'oxygène et/ou des atomes d'azote désigne un matériau réalisé en chrome dont les atomes sont agencés suivant la structure cristalline du chrome, des atomes d'oxygène et/ou des atomes d'azote étant insérés dans cette structure cristalline du chrome, et en particulier remplaçant des atomes de chrome dans cette structure cristalline.

Le dopage avec des atomes d'oxygène et/ou des atomes d'azote peut être réalisé par exemple au cours d'un dépôt physique en phase vapeur de la couche additionnelle 20.

Une implantation d'atomes d'oxygène et/ou d'atomes d'azote est généralement réalisée après un dépôt de chrome réalisé par exemple par dépôt physique en phase vapeur.

Les épaisseurs du substrat 14 et des couches du revêtement de protection 16 sont prises perpendiculairement à la surface du substrat 14 sur laquelle est déposée le revêtement de protection 16, ici la surface externe 14B.

Le substrat 14 présente par exemple une épaisseur comprise entre 0,4 mm et 1 mm.

La couche principale 18 présente par exemple une épaisseur strictement inférieure à celle du substrat 14.

La couche principale 18 présente par exemple une épaisseur comprise entre 3 µm et 30 µm, en particulier une épaisseur comprise entre 5 µm et 20 µm.

De préférence, l'épaisseur de chaque couche additionnelle 20 est strictement inférieure à l'épaisseur de la couche principale 18.

L'épaisseur de chaque couche additionnelle 20 est par exemple comprise entre 10 nm et 5 µm.

Sur les Figures 2 à 6, l'épaisseur du substrat 14 et les épaisseurs des différentes couches du revêtement de protection 16 ne sont pas représentées à l'échelle pour des raisons de clarté des dessins.

En option, le revêtement de protection 16 comprend une ou plusieurs couches de transition 22, chaque couche de transition 22 étant intercalée entre la couche principale 18 et une couche additionnelle 20 située sur la couche principale 18 ou sous la couche principale 18. Chaque couche de transition 22 est en contact d'un côté avec la couche principale 18 et de l'autre côté avec une couche additionnelle 20 située sur la couche principale 18 ou sous la couche principale 18.

Chaque couche de transition 22 est réalisée en chrome métallique dopé avec des atomes d'oxygène et/ou d'azote et/ou en chrome métallique dans lequel sont implantés des atomes d'oxygène et/ou d'azote.

Le matériau de chaque couche de transition 22 est constitué de chrome métallique dopé avec des atomes d'oxygène et/ou des atomes d'azote ou de chrome métallique dans lequel sont implantés des atomes d'oxygène et/ou des atomes d'azote, avec la présence éventuelle d'inévitables impuretés.

Le matériau de la couche de transition 22 se distingue d'un oxyde de chrome, d'un nitrure de chrome ou d'un oxynitrure de chrome en ce que le matériau de la couche de transition 22 est du chrome métallique possédant la structure cristalline du chrome et dans lequel sont inclus des atomes d'oxygène et/ou des atomes d'azote. Les atomes d'oxygène et/ou les atomes d'azote de la couche de transition 22 sont dispersés dans la structure cristalline du chrome métallique de la couche de transition 22.

Le taux d'atomes d'oxygène de la couche de transition 22 est le nombre d'atomes d'oxygènes rapporté au nombre total d'atomes par unité de volume. Le taux d'atomes d'oxygène est exemple exprimé en pourcentage d'atome d'oxygène dans le matériau.

De même, le taux d'atomes d'azote de la couche de transition 22 est le nombre d'atomes d'azote rapporté au nombre total d'atomes par unité de volume. Le taux d'atomes d'azote est exemple exprimé en pourcentage d'atome d'oxygène dans le matériau.

Avantageusement, le taux d'atome d'oxygène de la couche de transition 22 à son interface avec la couche additionnelle 20 adjacente est sensiblement égal au taux d'atomes d'oxygène de cette couche additionnelle 20.

Si la couche additionnelle 20 adjacente à la couche de transition 22 est réalisée en Cr₂O₃, le taux d'atomes d'oxygène de la couche de transition 22 à son interface avec cette couche additionnelle 20 est par exemple de 60%.

Au moins une couche de transition 22, et en particulier chaque couche de transition 22 présente de préférence un taux d'atome d'oxygène qui augmente, de préférence progressivement, selon l'épaisseur de la couche de transition 22, de la couche principale 18 vers la couche additionnelle 20 adjacente.

Dans un exemple de réalisation préféré, la couche additionnelle 20 adjacente à la couche de transition 22 est réalisée en oxyde de chrome Cr₂O₄ et le taux d'atomes d'oxygène de la couche de transition 22 augmente, de préférence progressivement, de la couche principale 18 à la couche additionnelle 20 adjacente d'une valeur de 0% jusqu'à une valeur de 60%.

En complément ou en option, le taux d'atome d'azote de chaque couche de transition 22 à son interface avec la couche additionnelle 20 adjacente est sensiblement égal au taux d'atomes d'azote de cette couche additionnelle 20.

Si la couche additionnelle 20 adjacente à la couche de transition 22 est réalisée en nitrure de chrome (CrN) le taux d'atomes d'oxygène de la couche de transition 22 à son interface avec cette couche additionnelle 20 est par exemple de 50%.

Au moins une couche de transition 22, et en particulier chaque couche de transition 22, présente de préférence un taux d'atome d'oxygène qui augmente, de préférence progressivement, selon l'épaisseur de la couche de transition 22, de la couche principale 18 vers la couche additionnelle 20 adjacente.

Dans un exemple de réalisation préféré, la couche additionnelle 20 adjacente à la couche de transition 22 est réalisée en oxyde de chrome CrO et le taux d'atomes d'oxygène de la couche de transition 22 augmente, de préférence progressivement, de la couche principale 18 à la couche additionnelle 20 adjacente d'une valeur de 0% jusqu'à une valeur de 50%.

Dans un exemple de réalisation particulier, au moins une couche de transition 22, et en particulier chaque couche de transition 22, présente de préférence un taux d'atomes d'oxygène et un taux d'atomes d'azote qui augmentent, de préférence progressivement, selon l'épaisseur de la couche de transition 22, de la couche principale 18 vers la couche additionnelle 20 adjacente.

L'épaisseur de chaque couche de transition 22 est par exemple comprise entre 10 nm et 1 µm.

Comme illustré sur la Figure 2, dans un exemple de réalisation, le revêtement de protection 16 comprend la couche principale 18 et une couche additionnelle 20 située sur la couche principale 18, une couche de transition 22 étant intercalée entre la couche principale 18 et la couche additionnelle 20.

La couche principale 18 est par exemple immédiatement adjacente au substrat 14. La couche principale 18 est en contact avec le substrat 14. La couche principale 18 est déposée directement sur le substrat 14.

La couche additionnelle 20 est réalisée par exemple en chrome pur, en oxyde de chrome et/ou en oxynitrure de chrome ou du chrome métallique dopé à l'oxygène et/ou l'azote ou du chrome dans lequel sont implantés des atomes d'oxygène et/ou des atomes d'azote. Dans un exemple de réalisation particulier, la couche additionnelle 20 est réalisée en oxyde de chrome, de préférence en Cr₂O₄ ou un oxyde de chrome amorphe.

La couche additionnelle 20 est de préférence la couche superficielle du revêtement de protection 16 (i.e. la couche en contact avec l'environnement extérieur).

Le revêtement de protection 16 est ici constitué de la couche principale 18, de la couche additionnelle 20 située sur la couche principale 18 et de la couche de transition 22 intercalée entre la couche principale 18 et la couche additionnelle 20.

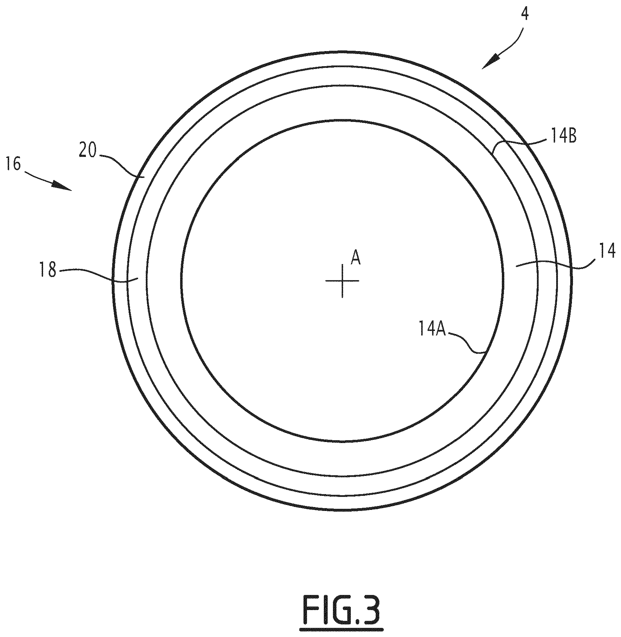

D'autres exemples de réalisation sont envisageables, comme illustré sur les Figures 3 à 6 sur lesquelles les références numériques aux éléments analogues ont été reprises.

La gaine 4 de la Figure 3 diffère de celle de la Figure 2 en ce qu'une couche additionnelle 20 est appliquée directement sur la couche principale 18. La couche additionnelle 20 est en contact avec la couche principale 18. La gaine 4 est dépourvue de couche de transition 22 entre la couche principale 18 et la couche additionnelle 20 située sur la couche principale 18.

Le revêtement de protection 16 est par exemple constitué de la couche principale 18 et de la couche additionnelle 20 située sur la couche principale 18.

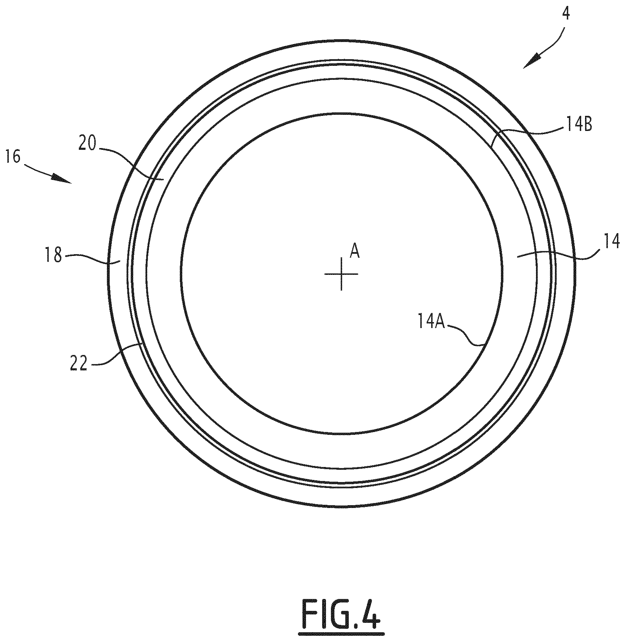

La gaine 4 de la Figure 4 diffère de celle de la Figure 2 en ce qu'une couche additionnelle 20 est située sous la couche principale 18, une couche de transition 22 étant intercalée entre la couche additionnelle 20 et la couche principale 18.

La couche additionnelle 20 est par exemple déposée directement sur le substrat 14, ici sur la surface externe 14B du substrat 14.

Le revêtement de protection 16 est par exemple constitué de la couche additionnelle 20, la couche principale 18 située sur la couche additionnelle 20, et la couche de transition 22 intercalée entre la couche additionnelle 20 et la couche principale 18.

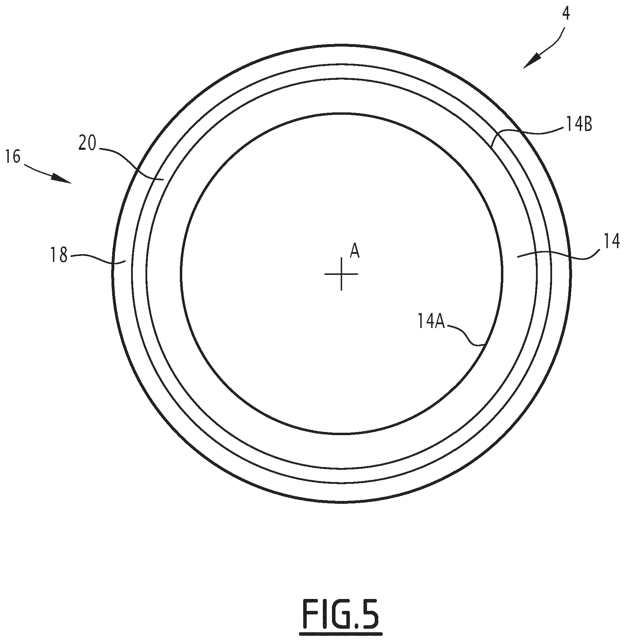

La gaine 4 de la Figure 5 diffère de celle de la Figure 4 en ce que la couche principale 18 est appliquée directement sur la couche additionnelle 20. La couche additionnelle 20 est en contact avec la couche principale 18. La gaine 4 est dépourvue de couche de transition 22 entre la couche additionnelle 20 et la couche principale 18 située sur la couche additionnelle 20.

Le revêtement de protection 16 est par exemple constitué de la couche additionnelle 20 déposée sur la surface externe 14B du substrat 14 et de la couche principale 18 située sur la couche additionnelle 20.

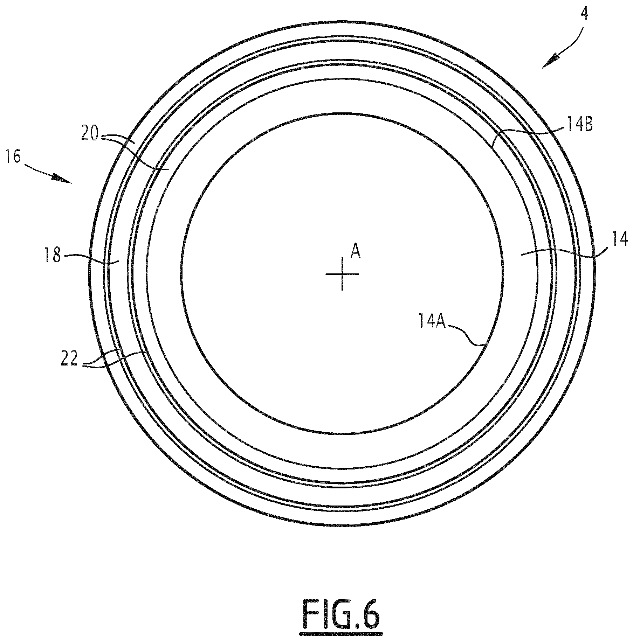

La gaine 4 de la Figure 6 diffère de celle de la Figure 2 en ce que le revêtement de protection 16 comprend une couche additionnelle 20 située sous la couche principale 18 et une couche additionnelle 20 située sur la couche principale 18. En option, une couche de transition 22 est intercalée entre la couche principale 18 et la couche additionnelle 20 située sous la couche principale 18. En option également, une couche de transition 22 est intercalée entre la couche principale 18 et la couche additionnelle 20 située sur la couche principale 18.

Le revêtement de protection 16 est par exemple constitué de la couche principale 18, d'une couche additionnelle 20 située sous la couche principale 18, d'une couche additionnelle 20 située sur la couche principale 18, d'une couche de transition 22 est intercalée entre la couche principale 18 et la couche additionnelle 20 située sous la couche principale 18 et d'une couche de transition 22 est intercalée entre la couche principale 18 et la couche additionnelle 20 située sur la couche principale 18.

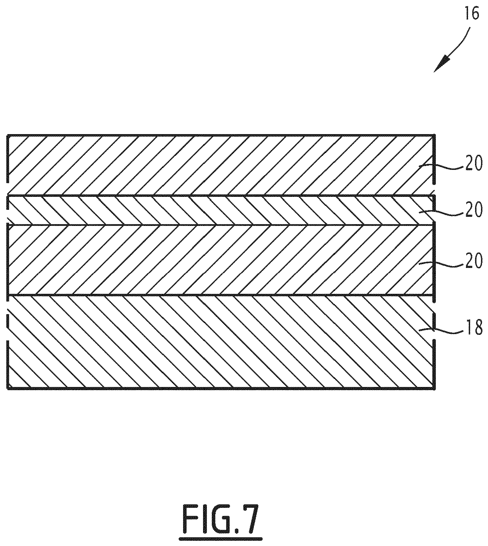

Comme illustré sur la Figure 7, dans un exemple de réalisation, un revêtement de protection 16 comprend au moins un groupe de plusieurs de couches additionnelles 20 adjacentes. Chaque couche additionnelle 20 de ce groupe est en contact avec la suivante dans l'empilement de couches du revêtement de protection 16. Sur la Figure 7, trois couches additionnelles 20 adjacentes sont représentées.

De préférence, chaque couches additionnelle 20 adjacente à une autre couche additionnelle 20 est réalisée dans un matériau différent de celui de cette autre couche additionnelle 20.Dans un exemple de réalisation, une couche additionnelle 20 réalisée en chrome pur est adjacente à une autre couche additionnelle 20 réalisée dans un matériau constitué de chrome et, en outre, d'oxygène et/ou d'azote, avec la présence éventuelle d'inévitables impuretés, en particulier dans un matériau en oxyde de chrome, en nitrure de chrome, en oxynitrure de chrome, en chrome métallique dopé avec des atomes d'oxygène et/ou des atome d'azote ou en chrome métallique dans lequel sont implantés des atomes d'oxygène et/ou des atomes d'azote.

Avantageusement, le groupe de plusieurs de couches additionnelles 20 adjacentes comprend au moins une couche additionnelle 20 réalisée en chrome pur qui est intercalée entre deux autres couches additionnelles 20, chacune de ces deux autres couches additionnelles 20 étant réalisée dans un matériau constitué de chrome et, en outre, d'oxygène et/ou d'azote, avec la présence éventuelle d'inévitables impuretés, en particulier dans un matériau en oxyde de chrome, en nitrure de chrome, en oxynitrure de chrome, en chrome métallique dopé avec des atomes d'oxygène et/ou des atome d'azote ou en chrome métallique dans lequel sont implantés des atomes d'oxygène et/ou des atomes d'azote.

Dans ce cas, les deux autres couches additionnelles 20 située de part et d'autre de chaque couche additionnelle 20 réalisée en chrome pur sont réalisées dans le même matériau ou dans des matériaux différents.

Dans un exemple de réalisation, chacune de ces deux autres couches additionnelles 20 est réalisée dans un matériau constitué de chrome et d'oxyde, par exemple en oxyde de chrome, ou dans un matériau constitué de chrome et d'azote, par exemple un nitrure de chrome.

Dans un exemple de réalisation particulier, la couche additionnelle 20 réalisée en chrome pur est intercalée entre deux autres couches additionnelles 20 réalisée en nitrure de chrome.

Dans un exemple de réalisation, le groupe de plusieurs couches additionnelles 20 adjacentes comprend au moins une couche additionnelle 20 réalisée en chrome pur disposée en alternance avec d'autres couches additionnelles 20, chacune de ces autres couches additionnelles 20 étant réalisée dans un matériau constitué de chrome et, en outre, d'oxygène et/ou d'azote, avec la présence éventuelle d'inévitables impuretés, en particulier dans un matériau en oxyde de chrome, en nitrure de chrome, en oxynitrure de chrome, en chrome métallique dopé avec des atomes d'oxygène et/ou des atome d'azote ou en chrome métallique dans lequel sont implantés des atomes d'oxygène et/ou des atomes d'azote.

Ces autres couches additionnelles 20 qui disposées en alternance avec la ou les couches additionnelles 20 réalisées en chrome pur, sont réalisées dans un même matériau ou dans au moins deux matériaux différents.

Dans un exemple de réalisation particulier, le groupe de couches additionnelles 20 adjacentes comprend une ou plusieurs couches additionnelles réalisée(s) en chrome pur en alternance avec des autres couches additionnelles 20 réalisées en nitrure de chrome.

Un revêtement de protection 16 peut comprendre un tel groupe de couches additionnelles 20 adjacente situé sur la couche principale 18 et/ou un tel groupe de couches additionnelles 20 adjacente situé sous la couche principale 18.

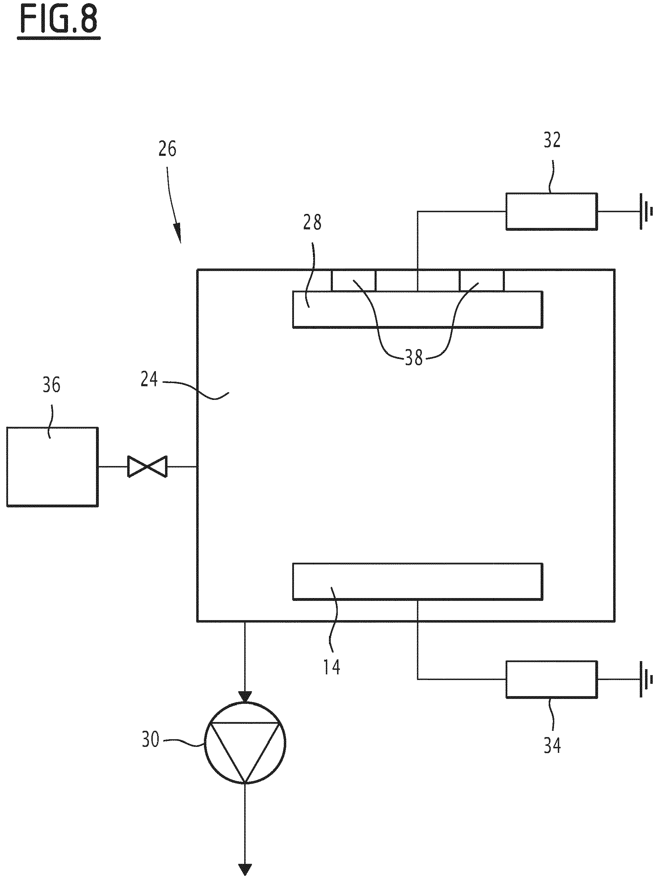

Un procédé de fabrication d'une gaine 4 va maintenant être décrit en référence à la Figure 8.

Le procédé de fabrication comprend une étape d'obtention du substrat 14. Lorsque le substrat 14 est un tube, il est par exemple obtenu de manière connue par laminage à pas de pèlerin, à partir d'une ébauche tubulaire de diamètre plus grand que celui du substrat 14, l'ébauche étant déformée de manière que son diamètre est progressivement réduit et que sa longueur progressivement augmentée, avant d'être éventuellement coupée à la longueur désirée pour obtenir le substrat 14.

Le procédé de fabrication comprend le dépôt de la couche principale 18 sur la surface externe 14B du substrat 14 par dépôt physique en phase vapeur.

Comme illustré sur la Figure 8, le dépôt physique en phase vapeur de la couche principale 18 est par exemple réalisé sous atmosphère contrôlée dans une chambre 24 d'une installation 26 de dépôt physique en phase vapeur, et en particulier sous atmosphère raréfiée et formée par exemple d'un gaz neutre, tel l'argon.

Le gaz neutre est choisi pour éviter des phénomènes d'oxydation pendant la phase de dépôt d'une couche du revêtement de protection 16 sur le substrat 14.

Le dépôt physique en phase vapeur est réalisé par exemple par pulvérisation cathodique ou par évaporation.

Dans un exemple de réalisation, la couche principale 18 est déposée par dépôt physique en phase vapeur par pulvérisation cathodique.

Pour ce faire, le substrat 14 et une cible 28 réalisée en chrome sont placés dans la chambre 24 dans laquelle est générée une atmosphère raréfiée formée par exemple d'un gaz neutre, tel l'argon, et un champ électrique est généré dans l'atmosphère raréfiée, entraînant l'apparition d'un plasma contenant des atomes et des particules chargées électriquement (électrons, ions...), qui sont précipitées sur la cible 28 sous l'effet du champ électrique et décrochent des atomes de la cible 28 (i.e. la cible 28 est pulvérisée, d'où le terme de pulvérisation cathodique), ces atomes détachés de la cible 28 allant ensuite se déposer sur le substrat 14.

L'installation 26 de dépôt physique en phase vapeur comprend la chambre 24, la cible 28 disposée à l'intérieur de la chambre 24, une pompe 30 dont l'entrée est reliée fluidiquement à la chambre 24 pour générer une atmosphère raréfiée dans la chambre 24, un générateur électrique 32 connecté à la cible 28, optionnellement, un générateur électrique 34 connecté au substrat 14, et un dispositif d'alimentation en gaz 36 relié fluidiquement à la chambre 24, par exemple pour fournir le gaz neutre (par ex. de l'argon), du dioxygène et/ou du diazote..

De préférence, le dépôt physique en phase vapeur est réalisé par pulvérisation cathodique magnétron. Dans ce cas, un champ magnétique est généré, de préférence au moins à proximité de la cible 28.

La prévision d'un champ magnétique permet de mieux contrôler la trajectoire des particules chargées électriquement atteignant la cible 28, ce qui permet une vitesse de dépôt de la couche principale 18 mieux contrôlée, en particulier une vitesse de dépôt plus élevée.

Le champ magnétique est généré par exemple par un ou plusieurs aimants permanents 38, comme illustré sur la Figure 3, et/ou un ou plusieurs électroaimants.

Le procédé de fabrication comprend le dépôt d'au moins une couche additionnelle 20, également par dépôt physique en phase vapeur.

Le dépôt de chaque couche additionnelle 20 est par exemple effectué dans la même installation 26 de dépôt physique en phase vapeur que le dépôt de la couche principale 18.

Le dépôt de chaque couche additionnelle 20 est effectué par exemple selon la même technique de dépôt physique en phase vapeur que celle utilisée pour réaliser le dépôt physique en phase vapeur de la couche principale 18.

Le dépôt de chaque couche additionnelle 20 est effectué par exemple par dépôt physique en phase vapeur par pulvérisation cathodique, en particulier par pulvérisation cathodique magnétron.

Le dépôt de chaque couche additionnelle 20 est effectué selon la même technique que le dépôt de la couche principale 18, mais diffère en ce qu'il est effectué, lorsque cela est nécessaire dans une atmosphère contrôlée contenant, en plus du gaz neutre, du dioxygène et/ou du diazote pour la formation d'une couche additionnelle formée d'oxyde de chrome, de nitrure de chrome, d'oxynitrure de chrome ou d'une combinaison de ces composés.

Le dioxygène et le diazote sont par exemple introduits dans la chambre 24 à l'aide du dispositif d'alimentation en gaz 36.

Dans un exemple de réalisation, seul du dioxygène est introduit dans l'atmosphère contrôlée en plus du gaz neutre. L'atmosphère contrôlée est un mélange gazeux binaire contenant le gaz neutre et le dioxygène. Ceci permet d'obtenir une couche additionnelle 20 en oxyde de chrome.

Dans un exemple de réalisation, seul du diazote est introduit dans l'atmosphère contrôlée. L'atmosphère contrôlée est un mélange gazeux binaire contenant le gaz neutre et le diazote. Ceci permet d'obtenir une couche additionnelle 20 en nitrure de chrome.

Dans un exemple de réalisation, du dioxygène et du diazote sont introduits dans l'atmosphère contrôlée en plus du gaz neutre. L'atmosphère contrôlée est un mélange gazeux ternaire contenant le gaz neutre, le dioxygène et le diazote. Ceci permet d'obtenir une couche additionnelle contenant de l'oxyde de chrome, du nitrure de chrome et/ou de l'oxynitrure de chrome.

Dans un exemple de réalisation, seul le gaz neutre est introduit dans l'atmosphère contrôlée. Ceci permet d'obtenir une couche additionnelle 20 en chrome pur.

Les couches du revêtement de protection 16 sont déposées successivement de la plus proche à la plus éloignée du substrat 14.

Chaque couche additionnelle 20 située sous la couche principale 18 est déposée avant la couche principale 18 et/ou chaque couche additionnelle 20 située sur la couche principale 18 est déposée après la couche principale 18
A l'issue du dépôt de la couche principale 18 et de chaque couche additionnelle 20, la gaine 4 comprend le substrat 14 dont la surface externe 14B est recouverte par le revêtement de protection 16.

Le cas échéant, le procédé de fabrication comprend la formation de chaque couche de transition 22.

Chaque couche de transition 22 est par exemple réalisée en déposant une couche de chrome par dépôt physique en phase vapeur tout en introduisant du dioxygène à l'état gazeux dans l'atmosphère de la chambre 24.

La formation d'une couche de transition 22 sur la couche principale 18 est par exemple réalisée à la suite du dépôt de la couche principale 18, en poursuivant le dépôt physique en phase vapeur du chrome tout en introduisant du dioxygène à l'état gazeux dans l'atmosphère de la chambre 24.

Pour la réalisation d'une couche de transition 22 possédant un taux d'atomes d'oxygène augmentant, de préférence progressivement, le taux de dioxygène dans l'atmosphère de la chambre 24 est par exemple augmenté ou diminué au cours du temps, de préférence progressivement.

En variante, au lieu d'introduire du dioxygène à l'état gazeux dans l'atmosphère de la chambre 24, il est possible d'introduire un produit oxygéné qui se décompose ou s'évapore en larguant du dioxygène dans l'atmosphère contrôlée.

En variante, la couche de transition 22 est obtenue après le dépôt de chrome par dépôt physique en phase vapeur sur une épaisseur correspondant à celle souhaitée pour la couche de transition 22, puis en réalisant une implantation ionique d'oxygène dans cette couche de chrome.

Chaque dépôt physique en phase vapeur (dépôt de la couche principale 18, dépôt de chaque couche additionnelle 20 et, le cas échéant, dépôt de chaque couche de transition 22) peut être réalisé avec une densité de courant continue (i.e. en appliquant un courant électrique continu à la cible 28) ou une densité de courant pulsée (i.e. en appliquant un courant électrique pulsé comprenant des impulsions).

Chaque dépôt physique en phase vapeur par pulvérisation cathodique magnétron peut être réalisé selon une des techniques suivantes ou une combinaison d'au moins deux parmi les techniques suivantes : pulvérisation cathodique magnétron en courant continu (en anglais « Direct Current » ou « DC »), pulvérisation cathodique magnétron en courant continu pulsé (en anglais « Pulsed Direct Current » ou « DC pulsed »), pulvérisation cathodique magnétron pulsée à haute puissance (en anglais « High Power Impulse Magnetron Sputtering» (HiPIMS ou HPMS), pulvérisation cathodique magnétron bipolaire (en anglais « Magnetron Sputtering Bi-polar » (MSB)), pulvérisation cathodique dual magnétron (en anglais « Dual Magnetron Sputtering » (DMS)), pulvérisation cathodique magnétron déséquilibrée (en anglais "Unbalanced Magnetron Sputtering » (UBM)).

Le dépôt du revêtement de protection 16 par dépôt physique en phase vapeur par pulvérisation cathodique magnétron est préféré, mais l'invention n'est pas limitée à une telle technique de dépôt.

En variante, le dépôt de chaque couche du revêtement de protection 16 peut être réalisé selon une autre technique, par exemple par dépôt physique en phase vapeur par évaporation, en particulier par dépôt physique en phase vapeur par arc électrique, ou par dépôt physique par projection à froid (en anglais « Cold Spray »).

L'ajout d'une couche principale 18 en chrome sur le substrat 14 permet d'améliorer la résistance à l'usure de la gaine 4 par rapport à une gaine 4 réalisée en zirconium pur ou en alliage à base de zirconium et non revêtue.

L'ajout en outre d'une couche additionnelle 20 réalisée en chrome pur ou en un matériau constitué d'oxyde de chrome, de nitrure de chrome, d'oxynitrure de chrome ou d'une combinaison de ces composés ou réalisée en chrome dopé à l'oxygène et/ou à l'azote, permet d'améliorer encore les performances de la gaine 4, en particulier en terme de résistance à l'usure, de résistance aux rayures et/ou de perméation aux produits de fission.

Chaque couche additionnelle 20 déposée par dépôt physique en phase vapeur peut être déposée de manière contrôlée, avec une épaisseur choisie, et en particulier suffisante pour obtenir les performances recherchées.

L'ajout d'une couche additionnelle 20 sur la couche principale 18 est susceptible d'améliorer la résistance à l'usure et aux rayures, du fait d'une dureté accrue par rapport à la couche principale 18. La résistance à l'usure permet de limiter la sensibilité de la gaine 4 à l'usure par vibration (ou « fretting » en anglais). La résistance aux rayures permet de limiter le risque de formation de rayures sur la surface externe de la gaine 4 lors de l'insertion du crayon de combustible nucléaire 2 à travers les grilles-entretoises d'un assemblage de combustible nucléaire.

Chaque couche additionnelle 20 située sur la couche principale 18 ou sous la couche principale 18, en particulier lorsqu'elle contient du Cr₂O₃, permet de limiter la perméation à travers la gaine 4 de produits de fission tel que le tritium provenant de l'intérieur de la gaine ou de produits de corrosion tel que l'hydrogène provenant de la surface externe.

L'hydrogène est susceptible d'augmenter la fragilité du substrat 14 réalisé en alliage à base de zirconium et le tritium peut polluer le fluide de refroidissement circulant dans le cœur du réacteur nucléaire.

Une couche additionnelle 20 située sur la couche principale 18 et contenant de l'oxyde de chrome, et en particulier du Cr₂O₃, peut aussi prendre une coloration noire avant même son insertion dans un cœur d'un réacteur nucléaire, ce qui peut être favorable aux transferts thermiques lors de phases transitoires du réacteur nucléaire, en particulier lors du démarrage du réacteur nucléaire.

Une couche additionnelle 20 située sous la couche principale 18, entre le substrat 14 et la couche principale 20, est susceptible de réduire la formation d'un eutectique Cr-Zr pour des températures élevées, typiquement pour des températures supérieures à 1330°C. La résistance de la gaine en cas de LOCA s'en trouve améliorée.

On notera que la formation naturelle d'un oxyde sur une gaine en alliage à base de zirconium se fait en quelques jours après la mise en présence d'eau sur la surface de la gaine. Par exemple la formation naturelle d'un oxyde sur une gaine en alliage à base de zirconium d'un crayon de combustible nucléaire se fait en environ cinq jours après l'insertion de l'assemblage de combustible nucléaire dans le cœur d'un réacteur nucléaire. L'épaisseur d'oxyde de zirconium ainsi formée sur la gaine atteint rapidement environ 100 nm et apporte rapidement une protection au substrat en alliage de zirconium.

A contrario, la formation naturelle d'un oxyde de chrome sur un revêtement de protection en chrome en présence d'eau sur le revêtement est lente, par exemple d'un facteur de 10 à 20 fois plus lente que pour un alliage à base de zirconium, et insuffisante pour apporter une protection au revêtement dès l'utilisation de la gaine dans un cœur d'un réacteur nucléaire. Une épaisseur d'oxyde de chrome de 100 nm est atteinte seulement après 500 jours en réacteur.

Le revêtement de protection comprenant au moins une couche additionnelle est déposé lors de la fabrication de la gaine.

Le dépôt d'un revêtement protection comprenant au moins une couche additionnelle lors de la fabrication de la gaine permet d'assurer une protection dès le début de l'usage de la gaine dans un cœur de réacteur nucléaire.

A ce titre, il faut noter que les dépôts des couches de chrome du revêtement de protection de chrome se font généralement en milieu inerte (avec gaz rare tel que l'argon) pour éviter des phénomènes d'oxydation pendant le dépôt du revêtement de la couche de chrome.

## Revendications

1. Gaine de combustible nucléaire, fabriquée avec un substrat (14) réalisé en zirconium pur ou en alliage à base de zirconium et un revêtement de protection (16) multicouche recouvrant une surface (14B) du substrat (14), le revêtement de protection (16) comprenant une couche principale (18) réalisée en chrome pur et une ou plusieurs couches additionnelles (20), chaque couche additionnelle (20) étant réalisée en chrome pur ou dans un matériau constitué de chrome et, en outre, d'oxygène et/ou d'azote, avec la présence éventuelle d'inévitables impuretés,
**caractérisé en ce que**
au moins une couche additionnelle (20) est réalisée en chrome métallique dopé avec des atomes d'oxygène et/ou des atomes d'azote ou dans lequel sont implantés des atomes d'oxygène et/ou des atomes d'azote.

2. Gaine selon la revendication 1, dans laquelle au moins une autre couche additionnelle (20) est réalisée en chrome pur, en oxyde de chrome, en nitrure de chrome ou en oxynitrure de chrome ou en une combinaison de ces matériaux.

3. Gaine selon la revendication 1 ou la revendication 2, comprenant une couche de transition (22) intercalée entre la couche principale (18) et une couche additionnelle (20) contenant de l'oxygène et/ou de l'azote, la couche de transition (22) étant réalisée en chrome métallique dopé avec des atomes d'oxygène et/ou des atomes d'azote ou en chrome métallique dans lequel sont implantés des atomes d'oxygène et/ou des atomes d'azote.

4. Gaine selon la revendication 3, dans laquelle la couche de transition (22) possède un taux d'atomes d'oxygène croissant progressivement de la couche principale (18) vers la couche additionnelle (20) et/ou possède un taux d'atomes d'azote croissant progressivement de la couche principale (18) vers la couche additionnelle (20).

5. Gaine selon la revendication 3 ou la revendication 4, dans laquelle le taux d'atomes d'oxygène de la couche de transition (22) à son interface avec la couche additionnelle (20) adjacente est sensiblement égal au taux d'atomes d'oxygène de la couche additionnelle (20) adjacente et/ou le taux d'atomes d'azote de la couche de transition (22) à son interface avec la couche additionnelle (20) adjacente est sensiblement égal au taux d'atomes d'azote de la couche additionnelle (20) adjacente.

6. Gaine selon l'une quelconque des revendications précédentes, dans laquelle l'épaisseur de la couche principale (18) est comprise entre 3 µm et 30 µm.

7. Gaine selon l'une quelconque des revendications précédentes, dans laquelle l'épaisseur de chaque couche additionnelle (20) est comprise entre 10 nm et 5 µm.

8. Gaine selon l'une quelconque des revendications précédentes, dans laquelle une couche additionnelle (20) est située sur la couche principale (18).

9. Gaine selon l'une quelconque des revendications précédentes, dans laquelle une couche additionnelle (20) est située sous la couche principale (18).

10. Procédé de fabrication d'une gaine de combustible nucléaire, le procédé de fabrication comprenant :
- la fourniture d'un substrat (14) réalisé zirconium pur ou en alliage à base de zirconium ; et
- le dépôt d'un revêtement de protection (16) multicouche sur une surface (14B) du substrat (14), le dépôt du revêtement de protection (16) comprenant le dépôt d'une couche principale (18) réalisée en chrome pur par dépôt physique en phase vapeur et le dépôt d'une ou plusieurs couches additionnelles (20), chaque couche additionnelle (20) étant réalisée en chrome pur ou en un matériau constitué de chrome et, en outre, d'oxygène et/ou d'azote, avec la présence éventuelle d'inévitables impuretés, dans lequel au moins une couche additionnelle est réalisée en chrome métallique dopé avec des atomes d'oxygène et/ou des atomes d'azote ou en chrome métallique dans lequel sont implantés des atomes d'oxygène et/ou des atomes d'azote.

11. Procédé de fabrication selon la revendication 10, dans lequel au moins une autre couche additionnelle (20) est réalisée en chrome pur, en oxyde de chrome, en nitrure de chrome ou en oxynitrure de chrome ou en une combinaison de ces matériaux.

12. Procédé de fabrication selon la revendication 10 ou la revendication 11, dans lequel au moins une couche additionnelle (20) est déposée par dépôt physique en phase vapeur.

13. Procédé de fabrication selon l'une quelconque des revendications 10 à 12, dans laquelle au moins une couche additionnelle (20) est déposée par dépôt physique en phase vapeur réalisée dans une atmosphère formée d'un mélange gazeux binaire ou ternaire contenant un gaz neutre et, en outre, du dioxygène et/ou du diazote.

14. Procédé de fabrication selon l'une quelconque des revendications 10 à 13, comprenant la formation d'une couche de transition (22) intercalée entre la couche principale (18) et une couche additionnelle (20), la couche de transition (22) étant réalisée en chrome dopé avec des atomes d'oxygène.

15. Procédé de fabrication selon la revendication 14, dans laquelle la couche de transition (22) possède un taux d'atomes d'oxygène croissant progressivement de la couche principale (18) vers la couche additionnelle (20) adjacente.

16. Procédé de fabrication selon l'une quelconque des revendications 10 à 15, dans laquelle l'épaisseur de la couche principale (18) est comprise entre 3 µm et 30µm.

17. Procédé de fabrication selon l'une quelconque des revendications 10 à 16, dans laquelle l'épaisseur de chaque couche additionnelle (20) est comprise entre 10 nm et 5 µm.

18. Procédé de fabrication selon l'une quelconque des revendications 10 à 17, dans lequel au moins une couche additionnelle (20) est déposée après la couche principale (18).

19. Procédé de fabrication selon l'une quelconque des revendications 10 à 18, dans lequel au moins une couche additionnelle (20) est déposée avant la couche principale (18).

## Patentansprüche

1. Kernbrennstoffhülle, hergestellt mit einem Substrat (14) aus reinem Zirkonium oder aus einer Legierung auf Zirkoniumbasis, und einer mehrschichtigen Schutzbeschichtung (16), die eine Oberfläche (14B) des Substrats (14) bedeckt, wobei die Schutzbeschichtung (16) eine aus reinem Chrom gebildete Hauptschicht (18) ist, und eine oder mehrere zusätzliche Schichten (20) umfasst, wobei jede zusätzliche Schicht (20) aus reinem Chrom oder aus einem Material , das aus Chrom besteht, gebildet ist und darüber hinaus aus Sauerstoff und/oder Stickstoff besteht, mit dem möglichen Vorhandensein unvermeidbarer Verunreinigungen, **dadurch gekennzeichnet, dass** mindestens eine zusätzliche Schicht (20) aus metallischem Chrom gebildet ist, das mit Sauerstoffatomen und/oder Stickstoffatomen dotiert ist oder in das Sauerstoffatome und/oder Stickstoffatome implantiert sind.

2. Hülle nach Anspruch 1, bei der mindestens eine weitere zusätzliche Schicht (20) aus reinem Chrom, aus Chromoxid, aus Chromnitrid oder aus Chromoxynitrid oder aus einer Kombination dieser Materialien gebildet ist.

3. Hülle nach Anspruch 1 oder Anspruch 2, umfassend eine Übergangsschicht (22), die zwischen der Hauptschicht (18) und einer zusätzlichen Schicht (20), die Sauerstoff und/oder Stickstoff enthält, angeordnet ist, wobei die Übergangsschicht (22) aus metallischem Chrom, das mit Sauerstoffatomen und/oder Stickstoffatomen dotiert ist, oder aus metallischem Chrom, in das Sauerstoffatome und/oder Stickstoffatome implantiert sind, gebildet ist.

4. Hülle nach Anspruch 3, bei der die Übergangsschicht (22) einen von der Hauptschicht (18) zur zusätzlichen Schicht (20) allmählich zunehmenden Anteil an Sauerstoffatomen aufweist und/oder einen von der Hauptschicht (18) zur zusätzlichen Schicht (20) allmählich zunehmenden Anteil an Stickstoffatomen aufweist.

5. Hülle nach Anspruch 3 oder Anspruch 4, bei der der Anteil an Sauerstoffatomen der Übergangsschicht (22) an ihrer Grenzfläche mit der angrenzenden zusätzlichen Schicht (20) im Wesentlichen gleich dem Anteil an Sauerstoffatomen der angrenzenden zusätzlichen Schicht (20) ist und/oder der Anteil an Stickstoffatomen der Übergangsschicht (22) an ihrer Grenzfläche mit der angrenzenden zusätzlichen Schicht (20) im Wesentlichen gleich dem Anteil an Stickstoffatomen der angrenzenden zusätzlichen Schicht (20) ist.

6. Hülle nach einem der vorhergehenden Ansprüche, bei der die Dicke der Hauptschicht (18) zwischen 3 µm und 30 µm liegt.

7. Hülle nach einem der vorhergehenden Ansprüche, bei der die Dicke jeder zusätzlichen Schicht (20) zwischen 10 nm und 5 µm liegt.

8. Hülle nach einem der vorhergehenden Ansprüche, bei der eine zusätzliche Schicht (20) auf der Hauptschicht (18) angeordnet ist.

9. Hülle nach einem der vorhergehenden Ansprüche, bei der eine zusätzliche Schicht (20) unter der Hauptschicht (18) angeordnet ist.

10. Herstellungsverfahren für eine Kernbrennstoffhülle, wobei das Herstellungsverfahren Folgendes umfasst:
- das Bereitstellen eines Substrats (14) aus reinem Zirkonium oder aus einer Legierung auf Zirkoniumbasis; und
- das Abscheiden einer mehrschichtigen Schutzbeschichtung (16) auf einer Oberfläche (14B) des Substrats (14), wobei das Abscheiden der Schutzbeschichtung (16) das Abscheiden einer Hauptschicht (18), die aus reinem Chrom gebildet ist, durch physikalische Gasphasenabscheidung und das Abscheiden einer oder mehrerer zusätzlicher Schichten (20) umfasst, wobei jede zusätzliche Schicht (20) aus reinem Chrom oder aus einem Material gebildet ist, das aus Chrom und darüber hinaus aus Sauerstoff und/oder Stickstoff besteht, mit dem möglichen Vorhandensein unvermeidbarer Verunreinigungen, wobei mindestens eine zusätzliche Schicht aus metallischem Chrom, das mit Sauerstoffatomen und/oder Stickstoffatomen dotiert ist, oder aus metallischem Chrom, in das Sauerstoffatome und/oder Stickstoffatome implantiert sind, gebildet ist.

11. Herstellungsverfahren nach Anspruch 10, bei dem mindestens eine weitere zusätzliche Schicht (20) aus reinem Chrom, aus Chromoxid, aus Chromnitrid oder aus Chromoxynitrid oder aus einer Kombination dieser Materialien gebildet ist.

12. Herstellungsverfahren nach Anspruch 10 oder Anspruch 11, bei dem mindestens eine zusätzliche Schicht (20) durch physikalische Gasphasenabscheidung abgeschieden wird.

13. Herstellungsverfahren nach einem der Ansprüche 10 bis 12, bei dem mindestens eine zusätzliche Schicht (20) durch physikalische Gasphasenabscheidung abgeschieden wird, die in einer Atmosphäre durchgeführt wird, die aus einem binären oder ternären Gasgemisch gebildet ist, das ein neutrales Gas und darüber hinaus molekularen Sauerstoff und/oder molekularen Stickstoff enthält.

14. Herstellungsverfahren nach einem der Ansprüche 10 bis 13, umfassend die Bildung einer Übergangsschicht (22), die zwischen der Hauptschicht (18) und einer zusätzlichen Schicht (20) angeordnet ist, wobei die Übergangsschicht (22) aus mit Sauerstoffatomen dotiertem Chrom gebildet ist.

15. Herstellungsverfahren nach Anspruch 14, bei dem die Übergangsschicht (22) einen von der Hauptschicht (18) zur angrenzenden zusätzlichen Schicht (20) allmählich zunehmenden Anteil an Sauerstoffatomen aufweist.

16. Herstellungsverfahren nach einem der Ansprüche 10 bis 15, bei dem die Dicke der Hauptschicht (18) zwischen 3 µm und 30 µm liegt.

17. Herstellungsverfahren nach einem der Ansprüche 10 bis 16, bei dem die Dicke jeder zusätzlichen Schicht (20) zwischen 10 nm und 5 µm liegt.

18. Herstellungsverfahren nach einem der Ansprüche 10 bis 17, bei dem mindestens eine zusätzliche Schicht (20) nach der Hauptschicht (18) abgeschieden wird.

19. Herstellungsverfahren nach einem der Ansprüche 10 bis 18, bei dem mindestens eine zusätzliche Schicht (20) vor der Hauptschicht (18) abgeschieden wird.

## Claims

1. A nuclear fuel cladding manufactured with a substrate (14) made of pure zirconium or of zirconium alloy and a multilayer protective coating (16) covering a surface (14B) of the substrate (14), the protective coating (16) comprising a main layer (18) made of pure chromium and one or a plurality of additional layers (20), each additional layer (20) being made of pure chromium or of a material consisting of chromium and, furthermore, of oxygen and/or of nitrogen, with the possible presence of unavoidable impurities, **characterized in that** at least one additional layer (20) is made of metallic chromium doped with oxygen atoms and/or nitrogen atoms or wherein oxygen atoms and/or nitrogen atoms are implanted.

2. The cladding according to claim 1, wherein at least one other additional layer (20) is made of pure chromium, chromium oxide, chromium nitride or chromium oxynitride or of a combination of such materials.

3. The cladding according to claim 1 or claim 2, comprising a transition layer (22) interposed between the main layer (18) and an additional layer (20) containing oxygen and/or nitrogen, the transition layer (22) being made of metallic chromium doped with oxygen atoms and/or nitrogen atoms or metallic chromium wherein oxygen atoms and/or nitrogen atoms are implanted.

4. The cladding according to claim 3, wherein the transition layer (22) has a concentration of oxygen atoms progressively increasing from the main layer (18) toward the additional layer (20) and/or has a concentration of nitrogen atoms progressively increasing from the main layer (18) toward the additional layer (20).

5. The cladding according to claim 3 or claim 4, wherein the concentration of oxygen atoms of the transition layer (22) at the interface thereof with the adjacent additional layer (20) is substantially equal to the concentration of oxygen atoms of the adjacent additional layer (20) and/or the concentration of nitrogen atoms of the transition layer (22) at the interface with the adjacent additional layer (20) is substantially equal to the concentration of nitrogen atoms of the adjacent additional layer (20).

6. The cladding according to any of the preceding claims, wherein the thickness of the main layer (18) is comprised between 3 µm and 30 µm.

7. The cladding according to any of the preceding claims, wherein the thickness of each additional layer (20) is comprised between 10 nm and 5 µm.

8. The cladding according to any of the preceding claims, wherein an additional layer (20) is located over the main layer (18).

9. A cladding according to any of the preceding claims, wherein an additional layer (20) is located under the main layer (18).

10. A method of manufacturing a nuclear fuel cladding, the manufacturing method comprising:
- the provision of a substrate (14) made of pure zirconium or of zirconium alloy; and
- the deposition of a multilayer protective coating (16) over a surface (14B) of the substrate (14), the deposition of the protective coating (16) comprising the deposition of a main layer (18) made of pure chromium by physical vapor deposition and the deposition of one or a plurality of additional layers (20), each additional layer (20) being made of pure chromium or of a material consisting of chromium and, furthermore, of oxygen and/or of nitrogen, with the possible presence of unavoidable impurities, wherein at least one additional layer is made of metallic chromium doped with oxygen atoms and/or nitrogen atoms or of metallic chromium wherein oxygen atoms and/or nitrogen atoms are implanted.

11. The manufacturing method according to claim 10, wherein at least one other additional layer (20) is made of pure chromium, chromium oxide, chromium nitride or chromium oxynitride or of a combination of such materials.

12. The manufacturing method according to claim 10 or claim 11, wherein at least one additional layer (20) is deposited by a physical vapor deposition.

13. The manufacturing method according to any of claims 10 to 12, wherein at least one additional layer (20) is deposited by physical vapor deposition performed in an atmosphere consisting of a binary or ternary gas mixture containing a neutral gas and, furthermore, of oxygen and/or of nitrogen.

14. The manufacturing method according to any of claims 10 to 13, comprising forming a transition layer (22) interposed between the main layer (18) and an additional layer (20), the transition layer (22) being made of chromium doped with oxygen atoms.

15. The manufacturing method according to claim 14, wherein the transition layer (22) has a concentration of oxygen atoms progressively increasing from the main layer (18) toward the adjacent additional layer (20).

16. The manufacturing method according to any of claims 10 to 15, wherein the thickness of the main layer (18) is comprised between 3 and 30 µm.

17. The manufacturing method according to any of claims 10 to 16, wherein the thickness of each additional layer (20) is comprised between 10 nm and 5 µm.

18. The manufacturing method according to any of claims 10 to 17, wherein at least one additional layer (20) is deposited after the main layer (18).

19. The training method according to any of claims 10 to 18, wherein at least one additional layer (20) is deposited before the main layer (18).
